# DEMANDE DE BREVET EUROPEEN

(11) **EP 1 376 149 A1**
(43) Date de publication de la demande: **02.01.2004**
(21) Numéro de dépôt: 02291594.6
(22) Date de dépôt: 26.06.2002
(51) Int. Cl.: G01S 1/24, H03K 7/04, H04L 25/49

(54) **Procédé et dispositif de commande d'un générateur d'impulsions pour l'émission d'un signal impulsionnel du type à bande ultra large modulé en position**

(71) Demandeur: STMicroelectronics S.A., 92120 Montrouge (FR); STMicroelectronics N.V., 1077 XX Amsterdam (NL)
(72) Inventeur: Helal, Didier, 74160 St-Julien en Genevois (FR); Lebowsky, Fritz, Palo Alto, CA 94303 (US)
(74) Mandataire: Casalonga, Axel

(57) **Abrégé**

Un générateur commandable d'impulsions génère les impulsions du signal impulsionnel respectivement contenues dans des fenêtres temporelles successives, et des moyens de commande élaborent un signal de commande pour le générateur contenant pour chaque impulsion une indication de sa position dans la fenêtre correspondante. Les moyens de commande (MCM) comportent des moyens de traitement (MT) aptes à délivrer pour chaque fenêtre temporelle, à une fréquence de délivrance Fe supérieure à la fréquence de répétition des impulsions, des groupes successifs (Gi) de N bits définissant ensemble une information numérique de position de l'impulsion à l'intérieur de ladite fenêtre, et des moyens de conversion (CHP, FFi) aptes à convertir cette information numérique de position en ledit signal de commande temporellement étalé sur la longueur de la fenêtre et comportant ladite indication de position à un instant correspondant à l'information numérique de position. Ceci permet de positionner ladite impulsion à l'intérieur de sa fenêtre avec une précision temporelle égale à 1/N.Fe .

## Description

L'invention concerne la technologie radio du type à bande ultra large (UWB « Ultra Wide Band » en langue anglaise) et plus particulièrement la commande d'un générateur d'impulsions pour l'émission d'un signal incident impulsionnel du type à bande ultra large véhiculant des informations numériques codées.

L'invention s'applique avantageusement mais non limitativement à la transmission de telles informations dans le cadre d'un réseau de transmission local sans fil.

La technologie du type à bande ultra large se distingue des technologies à bande étroite et spectre étalé, en ce sens que la largeur de bande du signal de type ultra large bande est typiquement comprise entre environ 25% et environ 100% de la fréquence centrale.

Par ailleurs, au lieu de transmettre une porteuse continue modulée avec de l'information ou avec de l'information combinée avec un code d'étalement, ce qui détermine la largeur de bande du signal, la technologie ultra large bande prévoit la transmission d'une série d'impulsions très étroites. Par exemple, ces impulsions peuvent prendre la forme d'un seul cycle, ou monocycle, ayant une largeur d'impulsion inférieure à 1 ns. Ces impulsions extrêmement courtes dans le domaine temporel, transformées dans le domaine fréquentiel, conduisent à l'obtention du spectre à bande ultra large caractéristique de la technologie UWB.

Dans la technologie UWB, l'information véhiculée sur le signal peut être codée par exemple par une modulation dite « de position d'impulsion » (PPM ;« Pulse Position Modulation » en langue anglaise). En d'autres termes, le codage d'information s'effectue en altérant l'instant d'émission des impulsions individuelles. Plus précisément, le train d'impulsions est émis à une fréquence de répétition pouvant aller jusqu'à plusieurs dizaines de MHz. Chaque impulsion est transmise dans une fenêtre de longueur prédéterminée, par exemple 50 ns. Par rapport à une position théorique d'émission, l'impulsion est alors en avance ou en retard, ce qui permet de coder un « 0 » ou un « 1 ». Il est également possible de coder plus de deux valeurs en utilisant plus de deux positions décalées par rapport à la position de référence. Il est également possible de superposer à cette modulation en position une modulation BPSK.

Compte tenu de la fréquence centrale des impulsions, qui est généralement de l'ordre de quelques GHz, et le décalage en position des impulsions par rapport à la position théorique qui est par exemple de l'ordre de quelques dizaines de picosecondes, il devient alors nécessaire d'utiliser des signaux d'horloge ayant des fréquences très élevées, par exemple de l'ordre de la centaine de GHz. Or, ceci nécessite l'utilisation de moyens contraignants, à la fois du point de vue technologique et du point de vue consommation en courant. Ainsi, il s'avère impossible actuellement de réaliser ces moyens en technologie CMOS.

Par ailleurs, il est important que la précision de l'horloge soit également très bonne, typiquement de quelques picosecondes, ce qui rajoute encore des contraintes technologiques.

L'invention vise à apporter une solution à ce problème.

Le but de l'invention est de proposer des moyens de commande du générateur d'impulsions pouvant être réalisés en technologie CMOS de façon particulièrement simple, et ce tout en offrant une précision compatible avec la modulation en position requise.

L'invention propose donc un procédé de commande d'un générateur d'impulsions pour l'émission d'un signal impulsionnel du type à bande ultra large modulé en position, dans lequel les impulsions du signal impulsionnel étant destinées à être contenues dans des fenêtres temporelles, on élabore un signal de commande pour le générateur contenant pour chaque impulsion une indication de sa position dans la fenêtre correspondante.

Selon une caractéristique générale de l'invention, on délivre pour chaque fenêtre temporelle, à une fréquence de délivrance Fe supérieure à la fréquence de répétition des impulsions, des groupes successifs de N bits définissant ensemble une information numérique de position d'une impulsion à l'intérieur de ladite fenêtre, et on convertit cette information numérique de position en ledit signal de commande temporellement étalé sur la longueur de la fenêtre et comportant ladite indication de position, à un instant correspondant à l'information numérique de position.

Ceci permet de positionner ladite impulsion à l'intérieur de sa fenêtre avec une précision temporelle égale à 1/N.Fe.

Ainsi, l'invention utilise en fait une sorte de conversion parallèle/série partant de groupes de N bits en parallèle pour aboutir à un signal de commande temporellement étalé et contenant à un instant donné l'indication de position de l'impulsion dans la fenêtre.

Et, le fait d'utiliser cette conversion parallèle/série permet de travailler avec un signal d'horloge à la fréquence Fe, par exemple quelques centaines de MHz, et d'obtenir une précision temporelle au moins de 100 picosecondes, par exemple de l'ordre de 50 picosecondes, ce qui correspond à un signal effectif d'horloge de 20 GHz.

En pratique, N pourra être une puissance entière de 2, par exemple 7.

Par ailleurs, bien que cela ne soit pas indispensable, la fréquence de délivrance Fe est avantageusement égale à un multiple de la fréquence de répétition des impulsions.

Selon un mode de mise en oeuvre prévoyant l'émission de plusieurs impulsions temporellement décalées à l'intérieur d'une même fenêtre temporelle, les groupes successifs de N bits définissent ensemble les information numériques de position des impulsions à l'intérieur de ladite fenêtre, et on convertit ces informations numériques de position en ledit signal de commande temporellement étalé sur la longueur de la fenêtre et comportant les indications de position, aux instants correspondant aux informations numériques de position.

Selon un mode de mise en oeuvre de l'invention, pour chaque fenêtre temporelle, un seul des groupes de N bits comporte un bit ayant une première valeur logique, par exemple la valeur 1, tandis que tous les autres bits de ce groupe ainsi que ceux des autres groupes ont une deuxième valeur logique, par exemple la valeur logique 0. Le bit ayant la première valeur logique définit alors par exemple l'instant initial de l'impulsion.

Selon un mode de mise en oeuvre de l'invention, la conversion de l'information numérique de position comporte
- l'élaboration à partir d'un signal d'horloge de base ayant la fréquence Fe, de N signaux d'horloge élémentaires ayant tous la même fréquence Fe mais mutuellement temporellement décalés de 1/N.Fe,
- la commande par les N signaux d'horloge élémentaires de N bascules recevant successivement les groupes de N bits, et
- la sommation des N sorties des N bascules.

L'invention a également pour objet un dispositif de génération d'un signal impulsionnel du type à bande ultra large modulé en position, comportant un générateur commandable d'impulsions apte à générer les impulsions du signal impulsionnel contenues dans des fenêtre temporelles, et des moyens de commande aptes à élaborer un signal de commande pour le générateur contenant pour chaque impulsion une indication de sa position dans la fenêtre correspondante.

Selon une caractéristique générale de l'invention, les moyens de commande comportent
- des moyens de traitement aptes à délivrer pour chaque fenêtre temporelle, à une fréquence de délivrance Fe supérieure à la fréquence de répétition des impulsions, des groupes successifs de N bits définissant ensemble une information numérique de position d'une impulsion à l'intérieur de ladite fenêtre, et
- des moyens de conversion aptes à convertir cette information numérique de position en ledit signal de commande temporellement étalé sur la longueur de la fenêtre et comportant ladite indication de position à un instant correspondant à l'information numérique de position,
ce qui permet de positionner ladite impulsion à l'intérieur de sa fenêtre avec une précision temporelle égale à 1/N.Fe.

Selon un mode de réalisation de l'invention, les moyens de conversion comportent
- un circuit d'horloge programmable recevant un signal d'horloge de base ayant la fréquence Fe et délivrant N signaux d'horloge élémentaires ayant tous la même fréquence Fe mais mutuellement temporellement décalés de 1/N.Fe,
- N bascules connectées en entrée à la sortie des moyens de traitement, respectivement commandées par les N signaux d'horloge élémentaires, et délivrant respectivement N signaux de sortie, et
- un sommateur à N entrées respectivement connectées aux sorties des N bascules, et délivrant ledit signal de commande.

Le circuit d'horloge programmable comprend de préférence une boucle numérique à verrouillage de phase comportant un oscillateur programmable en anneau délivrant les N signaux d'horloge élémentaires et commandé à partir d'un circuit de commande recevant les sorties respectives de N bascules recevant toutes le signal d'horloge de base et respectivement commandées par les N signaux d'horloge élémentaires.

L'utilisation d'une boucle numérique à verrouillage de phase en combinaison avec les moyens de conversion parallèle/série, permet d'obtenir une précision meilleure que quelques dizaines de picosecondes pour les déphasages mutuels (décalage temporel mutuel) des N signaux d'horloge élémentaires.

Les moyens de conversion, notamment la boucle numérique à verrouillage de phase, sont réalisés avantageusement en technologie CMOS, ce qui permet notamment de pouvoir placer les moyens de conversion dans un mode de veille au cours d'intervalles temporels prédéterminés. En d'autres termes, on peut mettre facilement le système en marche/arrêt, ce qui permet des économies d'énergie importantes.

L'invention a également pour objet un terminal d'un système de transmission sans fil, par exemple du type réseau local, incorporant un dispositif tel que défini ci-avant.

D'autres avantages et caractéristiques de l'invention apparaîtront à l'examen de la description détaillée de modes de réalisation et de mise en oeuvre, nullement limitatifs, et des dessins annexés, sur lesquels :
- la figure 1 illustre schématiquement un signal du type à bande ultra large ;
- la figure 2 illustre plus en détail mais toujours schématiquement un codage d'un bit par une modulation du type « position d'impulsion » (modulation PPM) ;
- la figure 3 illustre schématiquement un mode de réalisation d'un dispositif selon l'invention ;
- la figure 4 illustre plus en détail mais toujours schématiquement un mode de réalisation de moyens de commande d'un dispositif selon l'invention ;
- la figure 5 illustre plus en détail mais toujours schématiquement une partie des moyens de commande de la figure 4 ;
- la figure 6 représente un chronogramme temporel schématique des différents signaux d'horloge utilisés dans les moyens de commande ;
- la figure 7 illustre plus en détail mais toujours schématiquement une autre partie des moyens de commande d'un dispositif selon l'invention ; et
- les figures 8 et 9 illustrent schématiquement un mode de fonctionnement d'un dispositif selon l'invention.

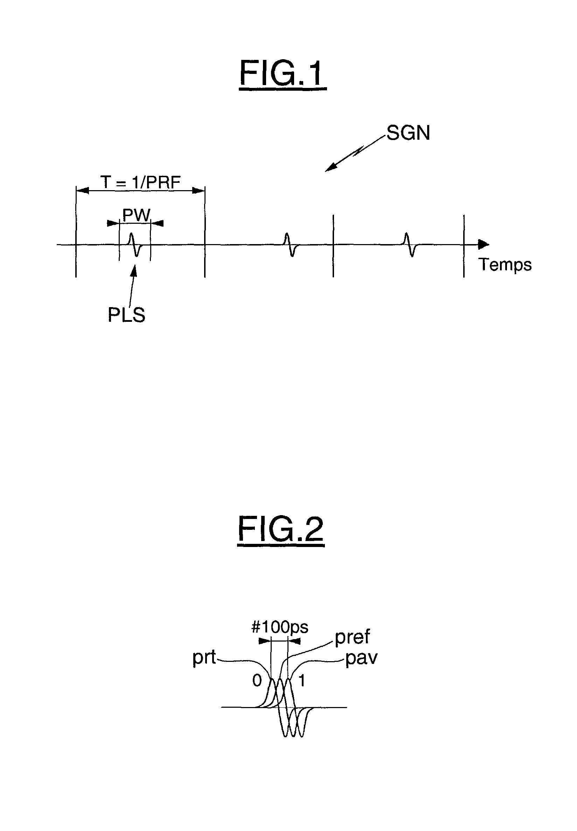

Sur la figure 1, la référence SGN désigne un signal impulsionnel initial du type à bande ultra large, comportant des impulsions PLS de forme théorique connue. Plus précisément, ces impulsions PLS ont une largeur temporelle prédéterminée PW, par exemple typiquement inférieure à 1 ns, par exemple de l'ordre de 360 picosecondes. Les impulsions successives PLS sont respectivement contenues dans des fenêtres temporelles successives de longueur T égale à l'inverse de la fréquence de répétition des impulsions (« Pulse Repetition Frequency » PRF selon une dénomination anglosaxonne). A titre indicatif, la longueur T de chaque fenêtre temporelle est par exemple égale à 50 ns. La position de chaque impulsion dans une fenêtre temporelle peut varier d'une fenêtre à l'autre en fonction d'un code pseudo-aléatoire. En outre, lorsque le signal véhicule des informations codées avec une modulation de position (modulation PPM), l'impulsion peut, comme illustrée sur la figure 2, être légèrement en avance (pav) ou légèrement en retard (prt) par rapport à la position de référence (pref) de l'impulsion dans la fenêtre, en fonction de la valeur « 0 » ou « 1 » de l'information transmise.

Les impulsions PLS possèdent des caractéristiques d'une impulsion du type à bande ultra large en ce sens que le rapport de la largeur de bande de l'impulsion à mi-puissance sur la fréquence centrale est supérieur à 1/4. A titre indicatif, la fréquence centrale d'une impulsion peut être de plusieurs GHz.

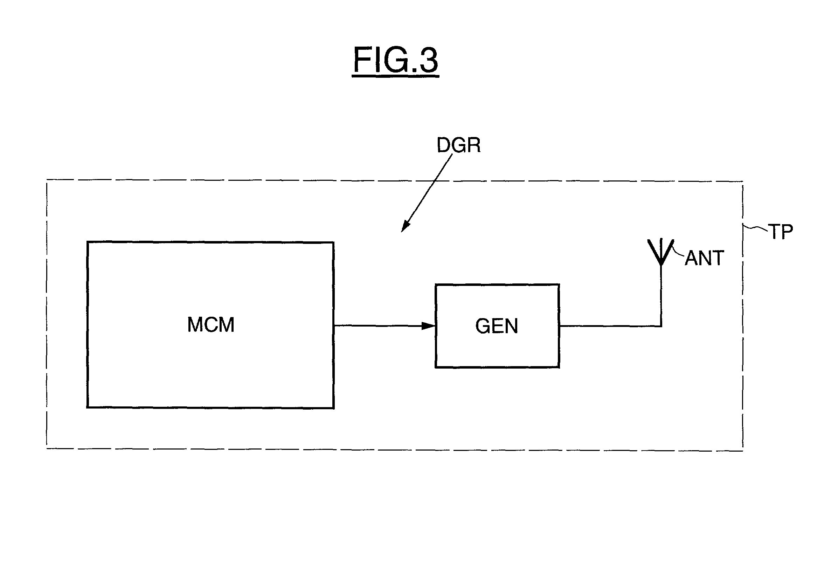

Le dispositif de génération DGR selon l'invention, dont un mode de réalisation est illustré sur la figure 3, et qui est avantageusement incorporé dans un terminal TP d'un réseau de communication local sans fil, va permettre de générer les impulsions successives du signal impulsionnel SGN destinées à être respectivement contenues dans les fenêtres temporelles successives de longueur T.

Ce dispositif DGR comporte un générateur d'impulsions GEN, de structure classique et connue en soi, dont la fonction est de générer l'impulsion à partir du moment où il en reçoit l'ordre à partir d'un signal de commande émis par des moyens de commande MCM. L'impulsion est ensuite transmise à l'antenne ANT pour être émise en direction de récepteurs de signaux UWB, de structures classiques et connues.

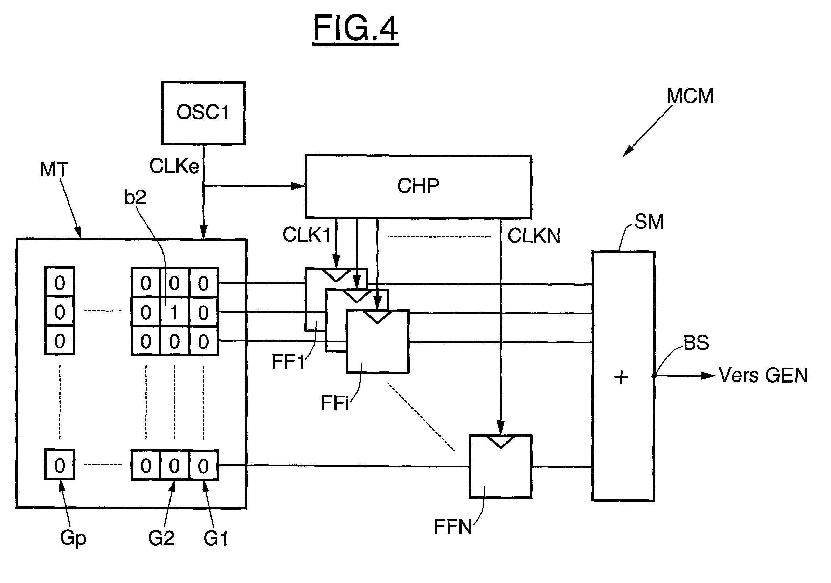

Si l'on se réfère maintenant à la figure 4, on voit que le moyen de commande comporte des moyens de traitement MT, aptes à délivrer pour chaque fenêtre temporelle de longueur T, et à une fréquence de délivrance Fe égale dans cet exemple à un multiple de la fréquence de répétition d'impulsion PRF, des groupes successifs G1-Gp de N bits, définissant ensemble une information numérique de position de l'impulsion à l'intérieur de ladite fenêtre. On reviendra plus en détail sur cette question ci-après.

Dans le cas particulier illustré sur la figure 4, la période T (longueur des fenêtres) est égale à p fois la période Te du signal d'horloge CLKe ayant la fréquence de délivrance Fe et fourni par exemple par un oscillateur à quartz OSC1.

Matériellement, les moyens de traitement MT peuvent comporter une mémoire comportant l'ensemble des bits, ainsi qu'un processeur associé à un registre de sortie, pour délivrer successivement au rythme du signal d'horloge CLKe les groupes successifs Gi de N bits.

Outre les moyens de traitement MT, les moyens de commande MCM comportent des moyens de conversion « parallèle/série » comportant un circuit d'horloge programmable CHP recevant le signal d'horloge de base CLKe et délivrant N signaux d'horloge élémentaires CLK1-CLKN, ayant tous la même fréquence Fe, mais mutuellement temporellement décalés de 1/N.Fe.

A titre indicatif, ces signaux d'horloge pourront être mutuellement temporellement décalés, de l'ordre de 50 picosecondes, par exemple.

Les moyens de conversion comportent également N bascules D, respectivement référencées FF1-FFN. Ces bascules sont respectivement commandées par les N signaux d'horloge élémentaires CLK1-CLKN et elles reçoivent en entrée les N bits de chacun des groupes successifs Gi.

Au rythme des fronts montants successifs des différents signaux d'horloge élémentaires CLK1-CLKN, les N bits de chaque groupe vont être successivement délivrés en sortie des bascules FFi sous la forme de signaux 0 ou 5 Volts par exemple (ces valeurs dépendant de la technologie utilisée) en fonction de la valeur des bits, et sommés dans un sommateur SM. Au bout de p fronts montants du signal d'horloge de base CLKe, les p groupes auront été traités et l'ensemble de l'information numérique de position aura été traité et converti après sommation SM en un signal de commande temporellement étalé sur la longueur de la fenêtre temporelle et destiné à commander le générateur d'impulsions GEN.

La position de l'impulsion, en l'occurrence son instant initial, est définie par la valeur logique 1 de l'un des bits de l'ensemble des groupes de bits, par exemple le bit b2 du groupe G2, sur la figure 4.

Par conséquent, ces moyens permettent de positionner l'instant initial de l'impulsion avec une précision temporelle égale à 1/N.Fe.

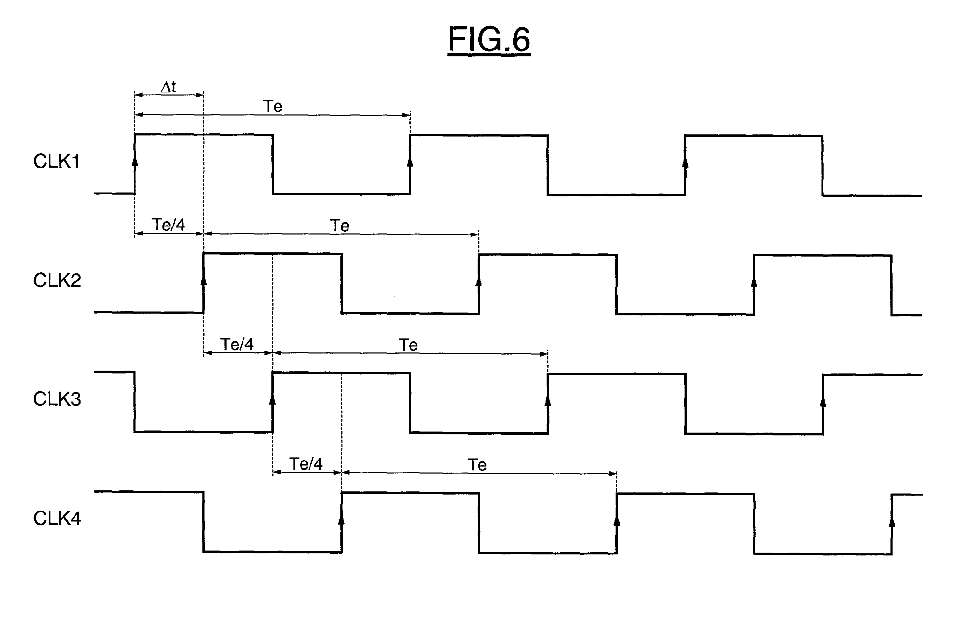

A titre d'exemple, on peut se référer à la figure 6, sur laquelle on a représenté à des fins de simplification uniquement quatre signaux d'horloge élémentaires CLK1-CLK4 (correspondant à N=4). En fait, comme on le voit sur la figure 6, le signal d'horloge de base CLKe est l'un des signaux d'horloge élémentaires, par exemple le signal CLK1.

En pratique, le circuit d'horloge programmable CHP peut être composé d'une horloge, par exemple un quartz, et d'un certain nombre d'éléments de retard montés en série à la sortie de l'horloge. A cet égard, l'homme du métier pourra éventuellement se référer à la demande de brevet européen n° 0 843 418.

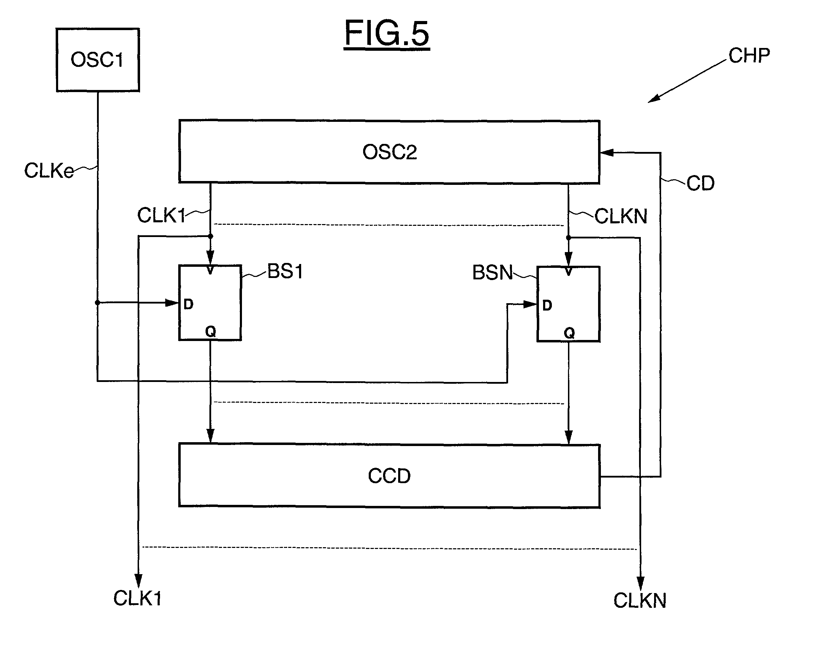

L'une des difficultés réside dans le fait qu'il convient de délivrer les signaux d'horloge élémentaires avec une précision (« jitter » en langue anglaise) très faible, par exemple de l'ordre de quelques picosecondes. C'est la raison pour laquelle il est alors avantageux que le circuit d'horloge programmable CHP comprenne une boucle numérique à verrouillage de phase comportant (figure 5) par exemple un oscillateur programmable en anneau OSC2, délivrant les N signaux d'horloge élémentaires CLK1-CLKN. Cet oscillateur en anneau est commandé à partir d'un circuit de commande CCD, recevant les sorties respectives de N bascules BS1-BSN. Ces N bascules sont respectivement commandées par les N signaux d'horloge élémentaires CLK1-CLKN et reçoivent sur leur entrée D le signal d'horloge de base CLKe issu par exemple d'un oscillateur classique à quartz OSC1.

L'homme du métier pourra, à cet égard, se référer, si nécessaire, au brevet américain n° 6 208 182, en ce qui concerne notamment la commande de l'oscillateur en anneau. On en rappelle ici cependant les principes généraux. Le circuit de commande CCD comporte des moyens pour comparer des échantillons deux à deux, de façon à déterminer si une transition d'état s'est produite dans un intervalle temporel séparant les deux échantillons, cette comparaison étant effectuée sur au moins deux cycles, consécutifs ou non, de l'oscillateur en anneau. Cette comparaison est effectuée de sorte que :
- si, durant le second cycle, une transition d'état comparable est détectée dans le même intervalle, la commande de l'oscillateur en anneau n'est pas modifiée,
- si, durant le second cycle, une transition d'état comparable est détectée dans un intervalle ultérieur, la période de l'oscillateur en anneau est diminuée, et
- si, durant le second cycle, une transition d'état comparable est détectée dans un intervalle antérieur, la période de l'oscillateur en anneau est augmentée.

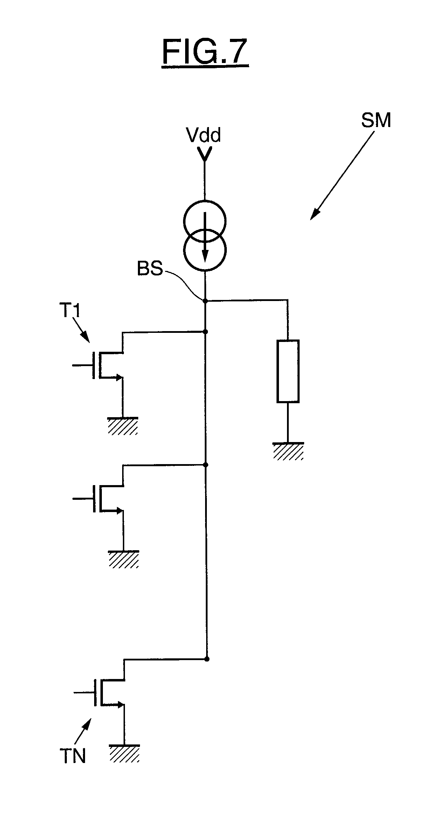

En ce qui concerne le sommateur SM, une façon de le réaliser est illustrée sur la figure 7. Plus précisément, on voit que le sommateur SM comporte ici N transistors NMOS, respectivement référencés T1-TN. La base de chaque transistor est reliée à la sortie de la bascule FF correspondante. Par ailleurs, les sources de ce transistor sont reliées à la masse et leur drain est relié à la tension d'alimentation Vdd. Les drains communs de ces transistors forment la borne de sortie BS.

En pratique, lorsque tous les bits d'un groupe sont à 0, les transistors sont bloqués. Par contre, lorsque l'un de ces bits, par exemple le bit b2, passe à 1, le transistor correspondant devient passant et la tension de sortie disponible à la borne BS, initialement à la valeur Vdd, est tirée vers la masse, provoquant le déclenchement du générateur d'impulsions.

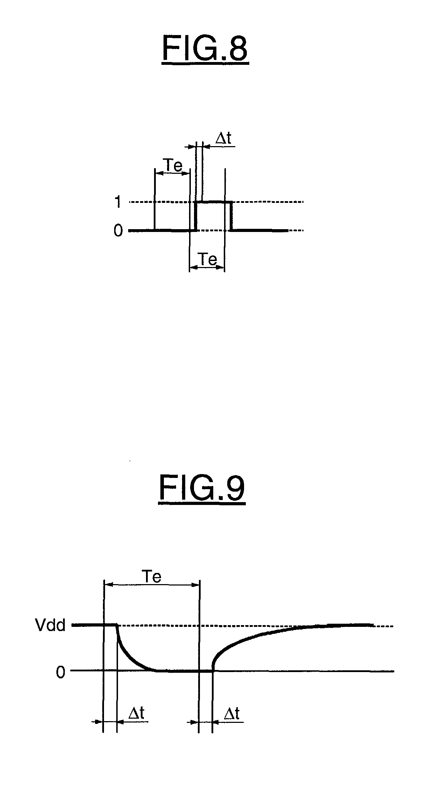

Plus précisément, ceci est illustré sur les figures 8 et 9.

Sur la figure 8, on voit que l'instant initial de l'impulsion, défini par le bit b2, se situe au cours de la deuxième période Te (puisque le bit 2 appartient au deuxième groupe G2) et avec un retard Δt égal à 1/N.Fe par rapport au début de la période (puisqu'il s'agit du deuxième bit).

Le signal délivré par la deuxième bascule FF2, illustré sur la figure 8, prend la valeur logique 1 lors du front montant du signal d'horloge élémentaire CLK2 et le garde jusqu'au prochain front montant de ce signal d'horloge élémentaire CLK2, c'est-à-dire pendant une période Te.

Corrélativement, comme illustré sur la figure 9, le signal en sortie du sommateur garde la valeur Vdd jusqu'à un instant postérieur de Δt après le début de la deuxième période Te, puis il décroît jusqu'à la valeur 0 pour remonter à la valeur Vdd à partir d'un instant retardé de Δt après la fin de cette deuxième période Te.

Ainsi, selon l'invention, les moyens de commande fonctionnent à la fréquence de délivrance Fe ( 200MHz par exemple) et permettent l'émission d'une seule impulsion par fenêtre de longueur T avec une précision temporelle de l'ordre de 50 picosecondes. Leur cadencement à la fréquence de délivrance autorise aisément une réalisation sous forme de circuit intégré en technologie CMOS.

L'invention n'est pas limitée aux modes de réalisation et de mise en oeuvre qui viennent d'être décrits mais en embrasse toutes les variantes. Ainsi, il serait possible d'émettre plusieurs impulsions temporellement décalées à l'intérieur d'une même fenêtre temporelle. Dans ce cas, les groupes successifs de N bits définissent ensemble les information numériques de position des impulsions à l'intérieur de ladite fenêtre ( plusieurs bits appartenant à des groupes différents peuvent prendre la valeur 1 par exemple), et les moyens de conversion sont aptes à convertir ces informations numériques de position en ledit signal de commande temporellement étalé sur la longueur de la fenêtre et comportant les indications de position, aux instants correspondant aux informations numériques de position.

## Revendications

1. Procédé de commande d'un générateur d'impulsions pour l'émission d'un signal impulsionnel du type à bande ultra large modulé en position, dans lequel les impulsions du signal impulsionnel étant destinées à être contenues dans des fenêtres temporelles, on élabore un signal de commande pour le générateur contenant pour chaque impulsion une indication de sa position dans la fenêtre correspondante, **caractérisé par le fait qu'**on délivre pour chaque fenêtre temporelle, à une fréquence de délivrance Fe supérieure à la fréquence de répétition des impulsions, des groupes successifs (Gi) de N bits définissant ensemble une information numérique de position d'une impulsion à l'intérieur de ladite fenêtre, et on convertit cette information numérique de position en ledit signal de commande temporellement étalé sur la longueur (T) de la fenêtre et comportant ladite indication de position à un instant correspondant à l'information numérique de position, ce qui permet de positionner ladite impulsion à l'intérieur de sa fenêtre avec une précision temporelle égale à 1/N.Fe.

2. Procédé selon la revendication 1, **caractérisé par le fait que** la précision temporelle est au moins de 100 picosecondes.

3. Procédé selon la revendication 2, **caractérisé par le fait que** N est une puissance de 2, et **par le fait que** la fréquence de délivrance est de l'ordre de 200MHz, et la précision temporelle de l'ordre de 50 picosecondes.

4. Procédé selon l'une des revendications précédentes, **caractérisé par le fait que** la fréquence de délivrance est un multiple de la fréquence de répétition des impulsions.

5. Procédé selon l'une des revendications précédentes, **caractérisé par le fait que** pour chaque fenêtre temporelle un seul des groupes (G2) de N bits comporte un bit (b2) ayant une première valeur logique, tous les autres bits de ce groupe et des autres groupes ayant une deuxième valeur logique, le bit ayant la première valeur logique définissant l'instant initial de l'impulsion.

6. Procédé selon l'une des revendications 1 à 4, **caractérisé par le fait que** plusieurs impulsions temporellement décalées étant destinées à être émises à l'intérieur d'une même fenêtre temporelle, les groupes successifs de N bits définissent ensemble les information numériques de position des impulsions à l'intérieur de ladite fenêtre, et on convertit ces informations numériques de position en ledit signal de commande temporellement étalé sur la longueur de la fenêtre et comportant les indications de position, aux instants correspondant aux informations numériques de position.

7. Procédé selon l'une des revendications précédentes, **caractérisé par le fait que** la conversion de l'information numérique de position comporte l'élaboration à partir d'un signal d'horloge de base (CLKe) ayant la fréquence Fe, de N signaux d'horloge élémentaires (CLK1-CLKN) ayant tous la même fréquence Fe mais mutuellement temporellement décalés de 1/N.Fe, la commande par les N signaux d'horloge élémentaires de N bascules (FFi) recevant successivement les groupes de N bits, et la sommation des N sorties des N bascules.

8. Dispositif de génération d'un signal impulsionnel du type à bande ultra large modulé en position, comportant un générateur commandable d'impulsions apte à générer les impulsions du signal impulsionnel contenues dans des fenêtres temporelles, et des moyens de commande aptes à élaborer un signal de commande pour le générateur contenant pour chaque impulsion une indication de sa position dans la fenêtre correspondante, **caractérisé par le fait que** les moyens de commande (MCM) comportent des moyens de traitement (MT) aptes à délivrer pour chaque fenêtre temporelle, à une fréquence de délivrance Fe supérieure à la fréquence de répétition des impulsions, des groupes successifs (Gi) de N bits définissant ensemble une information numérique de position d'une impulsion à l'intérieur de ladite fenêtre, et des moyens de conversion (CHP, FFi) aptes à convertir cette information numérique de position en ledit signal de commande temporellement étalé sur la longueur de la fenêtre et comportant ladite indication de position à un instant correspondant à l'information numérique de position, ce qui permet de positionner ladite impulsion à l'intérieur de sa fenêtre avec une précision temporelle égale à 1/N.Fe.

9. Dispositif selon la revendication 8, **caractérisé par le fait que** la précision temporelle est au moins de 100 picosecondes.

10. Dispositif selon la revendication 9, **caractérisé par le fait que** N est une puissance de 2, et **par le fait que** la fréquence de délivrance est de l'ordre de 200MHz, et la précision temporelle de l'ordre de 50 picosecondes.

11. Dispositif selon l'une des revendications 8 à 10, **caractérisé par le fait que** la fréquence de délivrance est un multiple de la fréquence de répétition des impulsions.

12. Dispositif selon l'une des revendications 8 à 11, **caractérisé par le fait que** pour chaque fenêtre temporelle un seul (G2) des groupes de N bits comporte un bit (b2) ayant une première valeur logique, tous les autres bits de ce groupe et des autres groupes ayant une deuxième valeur logique, le bit ayant la première valeur logique définissant l'instant initial de l'impulsion.

13. Dispositif selon l'une des revendications 8 à 11, **caractérisé par le fait que** plusieurs impulsions temporellement décalées étant destinées à être émises à l'intérieur d'une même fenêtre temporelle, les groupes successifs de N bits définissent ensemble les information numériques de position des impulsions à l'intérieur de ladite fenêtre, et les moyens de conversion sont aptes à convertir ces informations numériques de position en ledit signal de commande temporellement étalé sur la longueur de la fenêtre et comportant les indications de position, aux instants correspondant aux informations numériques de position.

14. Dispositif selon l'une des revendications 8 à 13, **caractérisé par le fait que** les moyens de conversion comportent un circuit d'horloge programmable (CHP) recevant un signal d'horloge de base (CLKe) ayant la fréquence Fe et délivrant N signaux d'horloge élémentaires (CLK1-CLKN) ayant tous la même fréquence Fe mais mutuellement temporellement décalés de 1/N.Fe, N bascules (FF1-FFN) connectées en entrée à la sortie des moyens de traitement, respectivement commandées par les N signaux d'horloge élémentaires, et délivrant respectivement N signaux de sortie, et un sommateur à N entrées respectivement connectées aux sorties des N bascules, et délivrant ledit signal de commande.

15. Dispositif selon la revendication 14, **caractérisé par le fait que** le sommateur comporte N transistors MOS dont les bases sont respectivement reliées aux sorties respectives des N bascules.

16. Dispositif selon la revendication 14 ou 15, **caractérisé par le fait que** le circuit d'horloge programmable (CHP) comprend une boucle numérique à verrouillage de phase comportant un oscillateur programmable en anneau (OSC2) délivrant les N signaux d'horloge élémentaires et commandé à partir d'un circuit de commande (CCD) recevant les sorties respectives de N bascules (BS1-BSN) recevant toutes le signal d'horloge de base (CLKe) et respectivement commandées par les N signaux d'horloge élémentaires.

17. Dispositif selon l'une des revendications 8 à 16, **caractérisé par le fait que** les moyens de conversion sont réalisés en technologie CMOS.

18. Terminal d'un système de transmission sans fil, par exemple du type réseau local, **caractérisé par le fait qu'**il incorpore un dispositif selon l'une des revendications 8 à 17.
